# EUROPEAN PATENT APPLICATION

(11) **EP 4 657 525 A2**
(43) Date of publication of application: **03.12.2025**
(21) Application number: 25202878.2
(22) Date of filing: 13.03.2020
(51) Int. Cl.: H01L 23/538

(54) **NESTED INTERPOSER PACKAGE FOR IC CHIPS**

(30) Priority: 03.07.2019 US 201916502622
(62) Divisional of application: 20163053.0
(71) Applicant: INTEL Corporation, Santa Clara, CA 95054 (US)
(72) Inventor: MALLIK, Debendra, Chandler, AZ 85226 (US); MAHAJAN, Ravi V., Chandler, AZ 85248 (US); SANKMAN, Robert, Phoenix, AZ 85044 (US); MANEPALLI, Rahul, Chandler, AZ 85249 (US); PIETAMBARAM, Srinivas, Chandler, AZ 85249 (US)
(74) Representative: 2SPL Patentanwälte PartG mbB

(57) **Abstract**

Embodiments disclosed herein include an electronic package (100, 200, 300) comprising an interposer (130), wherein the interposer comprises a first plurality of through interposer vias (134) through the interposer; and a second plurality of through interposer vias (134) through the interposer; a nested component (140) in the interposer, wherein the nested component is between the first plurality of through interposer vias and the second plurality of through interposer vias, the nested component comprising a frontside , a backside and a plurality of through component vias (144) between the front side and the backside; a die (120) coupled to the first plurality of through interposer vias by first interconnects (181) and coupled to the front side of the nested component by second interconnect (182); and a redistribution layer (354) below the interposer, the redistribution layer coupled to the first plurality of through interposer vias, the second plurality of through interposer vias, and the backside of the nested component.

## Description

### TECHNICAL FIELD

Embodiments of the present disclosure relate to electronic packaging, and more particularly, to multi-chip packaging architectures with one or more dies attached to an interposer and one or more components embedded in cavities in the interposer.

### BACKGROUND

The demand for increased performance and reduced form factor are driving packaging architectures towards multi-chip integration architectures. Multi-chip integration allows for dies manufactured at different process nodes to be implemented into a single electronic package. However, current multi-chip architectures result in larger form factors that are not suitable for some use cases, or are not otherwise desirable to end users.

### BRIEF DESCRIPTION OF THE DRAWINGS

Figure 1A is a cross-sectional illustration of an electronic package that comprises a heterogeneous nested interposer, in accordance with an embodiment.
Figure 1B is a zoomed in portion of Figure 1A that more clearly illustrates the interconnects between the die and the interposer and the die and a nested component, in accordance with an embodiment.
Figure 1C is a zoomed in portion of Figure 1A that illustrates an alignment correction provided by the interconnects attached to the interposer and the nested component, in accordance with an embodiment.
Figure 2A is a cross-sectional illustration of an electronic package that comprises a heterogeneous nested interposer, in accordance with an embodiment.
Figure 2B is a zoomed in portion of Figure 2A that more clearly illustrates the interconnects between the die and the interposer and the die and a nested component, in accordance with an embodiment.
Figure 2C is a zoomed in portion of Figure 2A that illustrates an alignment correction provided by the interconnects attached to the interposer and the nested component, in accordance with an embodiment.
Figure 3A is a cross-sectional illustration of an electronic package with a heterogeneous nested interposer that comprises a plurality of nested components, in accordance with an embodiment.
Figure 3B is a cross-sectional illustration of an electronic package with a heterogeneous nested interposer that comprises at least one nested component that does not include through component vias, in accordance with an embodiment.
Figure 3C is a cross-sectional illustration of an electronic package with a heterogeneous nested interposer that comprises at least one nested component that faces away from the die in the electronic package, in accordance with an embodiment.
Figure 3D is a cross-sectional illustration of an electronic package with a heterogeneous nested interposer that comprises a plurality of stacked components in a cavity, in accordance with an embodiment.
Figure 3E is a cross-sectional illustration of an electronic package with a heterogeneous nested interposer that comprises a redistribution layer over the interposer and the nested component, in accordance with an embodiment.
Figure 3F is a cross-sectional illustration of an electronic package with a heterogeneous nested interposer that comprises a redistribution layer, in accordance with an embodiment.
Figure 4A is a plan view illustration of an electronic package with a heterogeneous nested interposer, in accordance with an embodiment.
Figure 4B is a cross-sectional illustration of the electronic package in Figure 4A along line B-B', in accordance with an embodiment.
Figure 4C is a cross-sectional illustration of the electronic package in Figure 4A along line C-C', in accordance with an embodiment.
Figure 5 is a plan view illustration of an electronic package with a heterogeneous nested interposer that comprises a plurality of interposer substrates, in accordance with an embodiment.
Figure 6A is a cross-sectional illustration of a carrier with an adhesive, in accordance with an embodiment.
Figure 6B is a cross-sectional illustration after an interposer with a cavity and a nested component are attached to the carrier, in accordance with an embodiment.
Figure 6C is a cross-sectional illustration after a mold layer is disposed over the interposer and the nested component, in accordance with an embodiment.
Figure 6D is a cross-sectional illustration after vias are formed into the mold layer and intermediate pads are disposed over the vias, in accordance with an embodiment.
Figure 6E is a cross-sectional illustration after a first die and a second die are attached to the interposer and the nested component, in accordance with an embodiment.
Figure 6F is a cross-sectional illustration after the carrier is removed, in accordance with an embodiment.
Figure 6G is a cross-sectional illustration after bump openings are patterned into a solder resist layer over package side pads of the interposer and the nested component, in accordance with an embodiment.
Figure 6H is a cross-sectional illustration after package side bumps are attached to the interposer and the nested component, in accordance with an embodiment.
Figure 7A is a cross-sectional illustration of an interposer and a nested component attached to a carrier, in accordance with an embodiment.
Figure 7B is a cross-sectional illustration after a mold layer is disposed over the interposer and the nested component, in accordance with an embodiment.
Figure 7C is a cross-sectional illustration after the mold layer is recessed, to expose interposer pads and component pads, in accordance with an embodiment.
Figure 7D is a cross-sectional illustration after intermediate pads are disposed over the interposer pads and the component pads, in accordance with an embodiment.
Figure 7E is a cross-sectional illustration after a first die and a second die are attached to the interposer and the nested component, in accordance with an embodiment.
Figure 7F is a cross-sectional illustration after the carrier is removed, in accordance with an embodiment.
Figure 7G is a cross-sectional illustration after package side bumps are attached to the interposer and the nested component, in accordance with an embodiment.
Figure 8A is a cross-sectional illustration of an interposer and a nested component attached to a carrier, in accordance with an embodiment.
Figure 8B is a cross-sectional illustration after intermediate pads and bumps are disposed over interposer pads and component pads, in accordance with an embodiment.
Figure 8C is a zoomed in illustration of a portion of Figure 8B that more clearly illustrates a pair of intermediate pads on each interposer pad, in accordance with an embodiment.
Figure 8D is a zoomed in illustration of a portion of Figure 8B that illustrates an alignment correction provided by the intermediate pads, in accordance with an embodiment.
Figure 9 is a cross-sectional illustration of an electronic system that comprises a heterogeneous nested interposer, in accordance with an embodiment.
Figure 10 is a schematic of a computing device built in accordance with an embodiment.

### EMBODIMENTS OF THE PRESENT DISCLOSURE

Described herein are multi-chip packaging architectures with a heterogeneous nested interposer and methods of forming such electronic packages, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, current packaging solutions are beginning to use multi-die architectures. However, the inclusion of multiple dies in a single package is not without issue. In addition to the larger footprint of existing multi-die architectures, such systems also suffer from poor yield and reliability. Particularly, the interconnections between dies are difficult to control due to warpage and other alignment issues when using traditional packaging substrates. Accordingly, embodiments disclosed herein include electronic packages that utilize heterogeneous nested interposers.

Heterogeneous nested interposers, such as those described herein, include an interposer with one or more cavities. Nested components may be positioned in the cavities. One or more dies may be connected to the interposer and the nested components with interconnects. In an embodiment, the interconnects include intermediate pads that are positioned between the pads of the nested component and the die and between the pads of the interposer and the die. In some embodiments, the intermediate pads are connected to the interposer pads and the nested component pads by a via. In other embodiments, the intermediate pads are directly connected to the interposer pads and the nested component pads. The intermediate pads (and in some embodiments the vias) provide misalignment correction for misalignment between the interposer and the nested component. Accordingly, embodiments allow for high yields and reliability, even when fine pitched interconnects are used (e.g., when the nested component is a bridge between two dies).

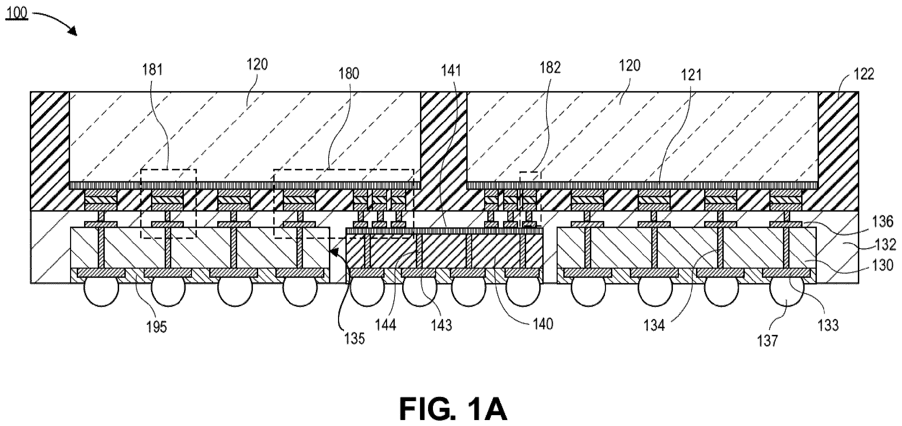

Referring now to Figure 1A, a cross-sectional illustration of an electronic package 100 is shown, in accordance with an embodiment. In an embodiment, the electronic package 100 may comprise an interposer 130 and a nested component 140. The nested component 140 is positioned within a cavity 135 that passes through the interposer 130. The nested component 140 is referred to as being "nested" because the component 140 is placed into the cavity 135. That is, the nested component 140 is surrounded by portions of the interposer 130. In the illustrated embodiment, a single cavity 135 is shown in the interposer 130. However, it is to be appreciated that any number of cavities 135 may be used, depending on the device. Examples of multiple cavities 135 are provided below in greater detail. In the illustrated embodiment, a single nested component 140 in the cavity 135 is shown. However, it is to be appreciated that any number of nested components 140 may be positioned in a single cavity 135. Examples of multiple nested components 140 in a single cavity 135 are provided below in greater detail.

In an embodiment, the interposer 130 may be any suitable substrate material. For example, the interposer 130 may comprise glass, ceramic, semiconductor materials (e.g., high or low resistivity silicon, III-V semiconductors, or the like), or organic substrates (high density interconnect (HDI) substrates, embedded trace substrates (ETS), high density package (HDP) substrates, molded substrates, or the like). In some embodiments, the interposer 130 is a passive device. That is, the interposer 130 may include only passive components (e.g., traces, vias, etc.). For example, the interposer 130 may comprise vias 134 that provide connections between pads 133 below the interposer 130 and pads 136 above the interposer 130. In other embodiments, the interposer 130 may be an active interposer. That is, the interposer 130 may comprise active devices (e.g., transistors etc.).

In an embodiment, the nested component 140 may be an active or passive component. For example, an active nested component 140 may comprise logic devices, analog/RF devices, I/O circuits, memory devices, voltage regulators, sensors, or the like. Passive nested components 140 may comprise high density multi-die interconnect bridge dies, capacitors, inductors, resistors, thermoelectric coolers, high speed connectors, or the like. In the illustrated embodiment, the nested component 140 comprises an active surface 141. While referred to as an "active" surface 141, it is to be appreciated that the active surface 141 may comprise entirely passive features. In an embodiment, the nested component 140 may comprise through component vias (TCVs) 144. The TCVs 144 may electrically couple the active surface 141 to pads 143 on the backside of the nested component 140.

In an embodiment, the interposer 130 and the nested component 140 may be embedded by a mold layer 132. The mold layer 132 may fill the remaining portions of the cavity 135. That is, portions of the mold layer 132 may be positioned between sidewalls of the nested component 140 and sidewalls of the interposer 130. In an embodiment, the mold layer 132 may cover top surfaces of the nested component 140 and top surfaces of the interposer 130.

In an embodiment, pads 133 of the interposer 130 and pads 143 of the nested component 140 may be contacted by bumps 137 positioned in openings through a solder resist 195 around the pads 133 and the pads 143. In an embodiment, the bumps 137 may be referred to as "package side bumps" (PSBs). The PSBs may interface with a package substrate (not shown).

In an embodiment, the electronic package 100 may further comprise one or more dies 120 embedded in a mold layer 122. In an embodiment, the active surfaces 121 of the dies 120 may be electrically coupled to the interposer 130 and the nested component 140. For example, interconnects 181 provide electrical connections between the die 120 and the interposer 130, and interconnects 182 provide electrical connections between the die 120 and the nested component 140. In an embodiment, the interconnects 181 may have a different pitch than the interconnects 182. For example, the interconnects 182 may have a smaller pitch than the interconnects 181. In the illustrated embodiment, the nested component 140 is a bridge that provides an electrical connection between the two dies 120.

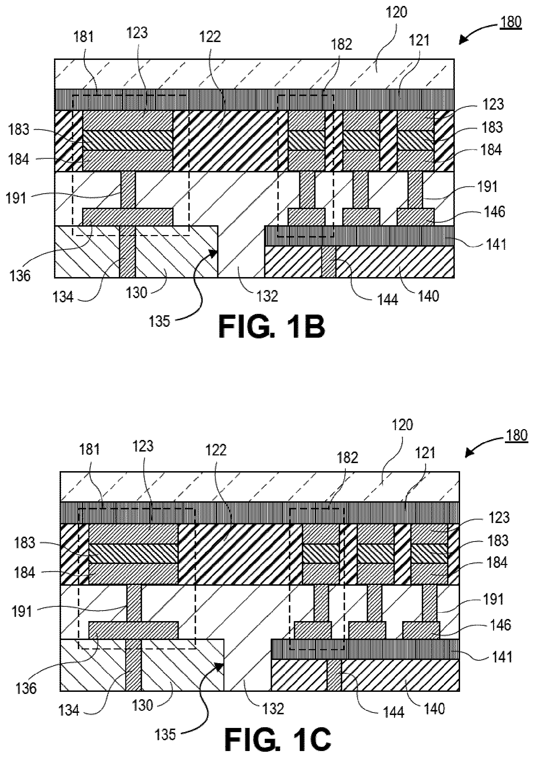

Referring now to Figure 1B, a zoomed in portion 180 of the electronic package 100 is shown, in accordance with an embodiment. Portion 180 illustrates more clearly the architecture of the interconnects 181 and 182. As shown, the interconnects 181 and 182 are substantially similar to each other, with the exception that the widths of the interconnects 182 are smaller than the widths of the interconnects 181. In an embodiment, the interconnects comprise an intermediate pad 184. The intermediate pads 184 may be positioned over a top surface of the mold layer 132. A bump 183 (e.g., a solder bump) may be positioned over the intermediate pads 184. The bumps 183 may be electrically coupled to die pads 123 of the die 120.

In an embodiment, the intermediate pads 184 may be electrically coupled to interposer pads 136 or component pads 146 by vias 191. The vias 191 may extend through a portion of the mold layer 132. In the illustrated embodiment, the vias 191 are illustrated as having substantially vertical sidewall profiles. Such an embodiment may be provided when the via openings are lithographically defined. However, it is to be appreciated that embodiments may also comprise vias 191 with tapered sidewall profiles. Such embodiments are typically formed when the via openings are formed with a laser drilling process.

The use of intermediate pads 184 and vias 191 provides interconnects 181 and 182 that have an improved alignment to the die 120. Particularly, since the nested component 140 is placed into the cavity 135 of the interposer 130, there may be some degree of misalignment between the interposer pads 136 and the component pads 146. However, since the vias 191 may all be formed with a single lithography operation, they will be aligned with each other. Similarly, the intermediate pads 184 may be fabricated with a single lithography process that aligns the intermediate pads 184 to each other. In Figure 1B, the interposer 130, the nested component 140, and the die 120 are shown as being perfectly aligned, and the benefit of alignment correction capabilities of the interconnects 181 and 182 are not clearly evident.

Referring now to Figure 1C, a cross-sectional illustration of the portion 180 that more clearly exhibits the benefits of the alignment correction features is shown, in accordance with an embodiment. As shown in Figure 1C, the nested component 140 is offset from the center of the cavity 135. Accordingly, the component pads 146 are misaligned with respect to the interposer pads 136. However, the vias 191 are all aligned with respect to each other, and the intermediate pads 184 are all aligned with respect to each other. For example, the centerlines of the vias 191 over the component pads 146 are not aligned with the centerlines of the component pads 146. So long as the vias 191 land on some surface of the component pads 146 (without also landing on a neighboring component pad 146) the misalignment can be corrected. In Figure 1C, the centerline of the via 191 over the interposer pad 136 is shown as being substantially aligned with the centerline of the interposer pad 136. However, it is to be appreciated that the via 191 may be shifted with respect to the interposer pad 136 in some embodiments.

In Figure 1C, misalignment in the X direction is shown. That is, the vias 191 may provide misalignment correction in the X-Y plane. However, it is to be appreciated that the vias 191 may also provide Z-height corrections as well. For example, if the thickness of the interposer 130 and the nested component 140 are not uniform, then vias of different heights can be used to provide a uniform Z-height for subsequent connections.

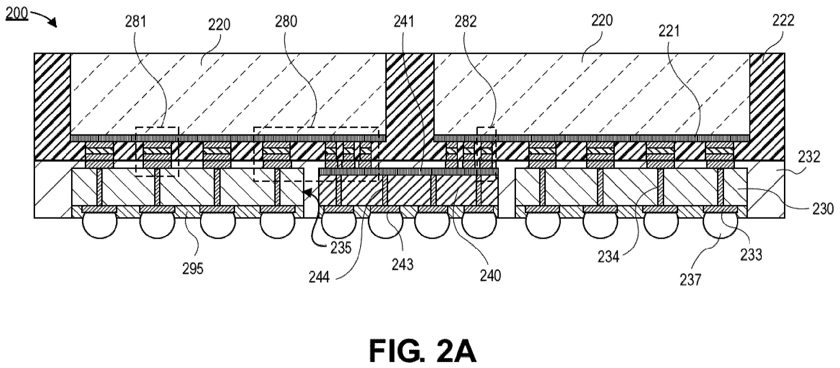

Referring now to Figure 2A, a cross-sectional illustration of an electronic package 200 is shown, in accordance with an additional embodiment. In an embodiment, the electronic package 200 may be substantially similar to the electronic package 100 described above, with the exception that the interconnects 281 and 282 are modified. For example, the electronic package 200 may comprise an interposer 230 with a cavity 235 and a nested component 240 in the cavity 235. The interposer 230 and the nested component 240 may be embedded in a mold layer 232. Active surfaces 221 of the dies 220 may be connected to the interposer 230 and the nested component 240 by interconnects 281 and 282. The dies 220 may be embedded in a mold layer 222. In an embodiment, the interposer 230 may include vias 234 that provide connection to pads 233 and bumps 237, and the nested component 240 may comprise vias 244 that connect an active surface 241 to pads 243 and bumps 237. Solder resist 295 may be positioned around the pads 233 and 243.

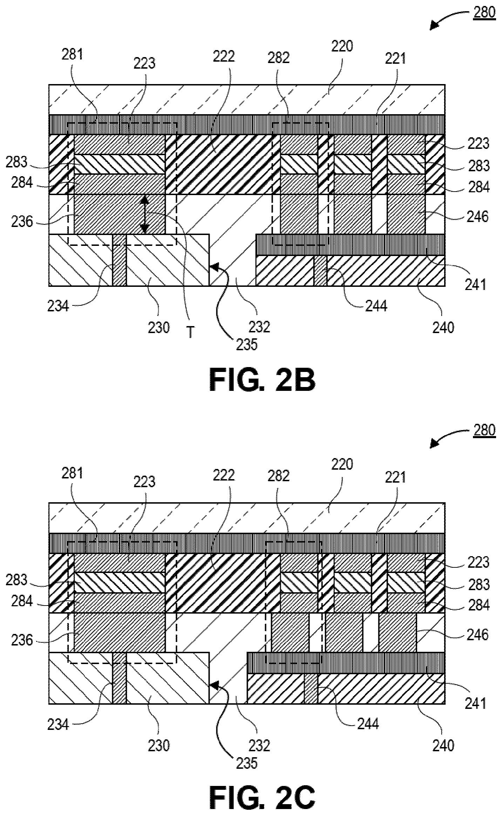

Referring now to Figure 2B, a zoomed in cross-sectional illustration of region 280 in Figure 2A that more clearly illustrates the interconnects 281 and 282 is shown, in accordance with an embodiment. As shown, the interconnects 281 and 282 are substantially similar to each other, with the exception that the widths of the interconnects 282 are smaller than the widths of the interconnects 281. In an embodiment, the interconnects comprise an intermediate pad 284. The intermediate pads 284 may be positioned over a top surface of the mold layer 232. A bump 283 (e.g., a solder bump) may be positioned over the intermediate pads 284. The bumps 283 may be electrically coupled to die pads 223 of the die 220.

In an embodiment, the intermediate pads 284 may be directly connected to interposer pads 236 or component pads 246. Instead of using vias (as shown in Figures 1A-1C), the interposer pads 236 and the component pads 246 have a thickness T that extends through the mold layer 232. Accordingly, the interposer pads 236 and the component pads 246 provide the same functionality provided by the vias 191 in Figures 1A-1C.

The use of intermediate pads 284 provides interconnects 281 and 282 that have an improved alignment to the die 220. Particularly, since the nested component 240 is placed into the cavity 235 of the interposer 230, there may be some degree of misalignment between the interposer pads 236 and the component pads 246. However, since the intermediate pads 284 may all be formed with a single lithography operation, they will be aligned with each other. In Figure 2B, the interposer 230, the nested component 240, and the die 220 are shown as being perfectly aligned, and the benefit of alignment correction capabilities of the interconnects 281 and 282 are not clearly evident.

Referring now to Figure 2C, a cross-sectional illustration of the region 280 that more clearly exhibits the benefits of the alignment correction features is shown, in accordance with an embodiment. As shown in Figure 2C, the nested component 240 is offset from the center of the cavity 235. Accordingly, the component pads 246 are misaligned with respect to the interposer pads 236. However, the intermediate pads 284 are all aligned with respect to each other. For example, the centerlines of the intermediate pads 284 over the component pads 246 are not aligned with the centerlines of the component pads 246. So long as the intermediate pads 284 land on some surface of the component pads 246 (without also landing on a neighboring component pad 246) the misalignment can be corrected. In Figure 2C, the centerline of the intermediate pad 284 over the interposer pad 236 is shown as being substantially aligned with the centerline of the interposer pad 236. However, it is to be appreciated that the intermediate pad 284 may be shifted with respect to the interposer pad 236 in some embodiments.

In Figure 2C, misalignment in the X direction is shown. That is, the intermediate pads 284 may provide misalignment correction in the X-Y plane. However, it is to be appreciated that thick interposer pads 236 and component pads 246 may also provide Z-height corrections as well. The use of interposer pads 236 and component pads 246 to provide Z-height corrections will be described in greater detail below.

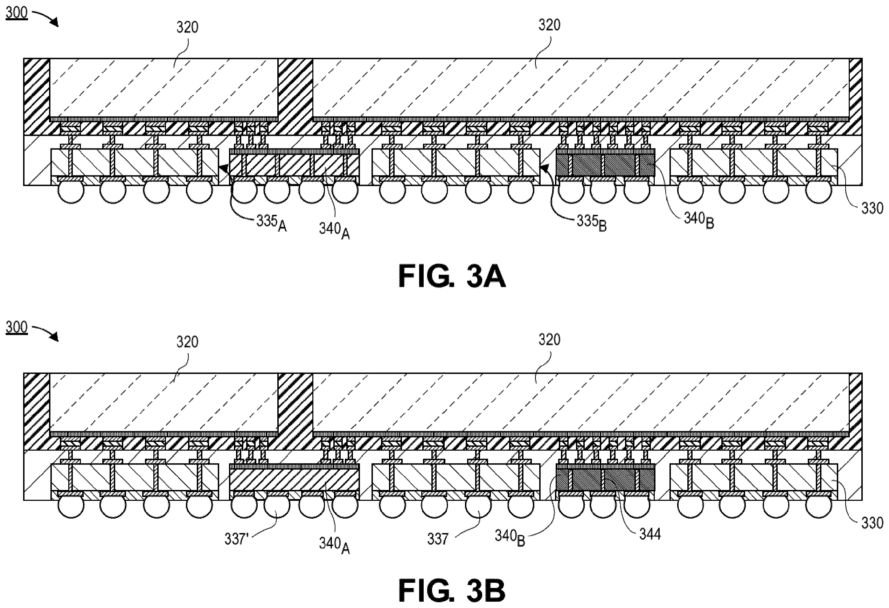

Referring now to Figures 3A-3F, a series of cross-sectional illustrations depict electronic packages 300 in accordance with additional embodiments. In Figures 3A-3F, the electronic packages 300 include interconnects between the die 320 and the interposer 330 and between the die 320 and the nested components 340 that are similar to those illustrated and described with respect to Figures 1A-1C. However, it is to be appreciated that substantially similar electronic packages 300 may be implemented using interconnects between the die 320 and the interposer 330 and between the die 320 and the nested components 340 that are substantially similar to the interconnects described above with respect to Figures 2A-2C.

Referring now to Figure 3A, a cross-sectional illustration of an electronic package 300 is shown, in accordance with an additional embodiment. In an embodiment, the electronic package 300 may be substantially similar to the electronic package 100 in Figure 1A, with the exception that a plurality of nested components 340 are provided in the interposer 330. As shown, a first nested component 340_{A} is positioned in a first cavity 335_{A} in the interposer 330 and a second nested component 340_{B} is positioned in a second cavity 335_{B}. In an embodiment, the first cavity 335_{A} may span between two dies 320. That is, the first cavity 335_{A} may be partially within a footprint of both dies 320. Accordingly, the first nested component 340_{A} may be accessible by both dies 320. For example, the first nested component 340_{A} may be a bridge that electrically couples the dies 320 together. In an embodiment, the second cavity 335_{B} may be entirely within a footprint of one of the dies 320. In such embodiments, the second nested component 340_{B} may be accessible to only one of the dies 320.

Referring now to Figure 3B, a cross-sectional illustration of an electronic package 300 is shown, in accordance with an additional embodiment. In an embodiment, the electronic package 300 in Figure 3B may be substantially similar to the electronic package 300 in Figure 3A, with the exception that the first nested component 340_{A} does not include TCVs 344. In some embodiments, the first nested component 340_{A} may comprise dummy balls 337'. That is, in some embodiments the dummy balls 337' may not be electrically connected to circuitry of the package 300 and serve as mechanical supports only, whereas balls 337 provide mechanical support and are electrically connected to circuitry of the package 300. In such an embodiment, the nested component 340_{A} may source power or signals from the package substrate (not shown) indirectly through the dies 320 via the top-side of the nested component 340_{A}.

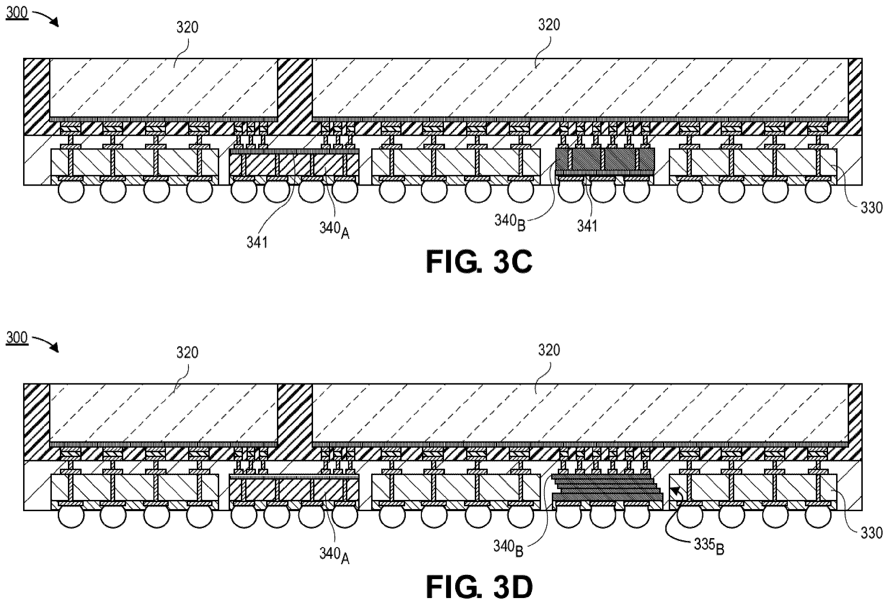

Referring now to Figure 3C, a cross-sectional illustration of an electronic package 300 is shown, in accordance with an embodiment. In an embodiment, the electronic package 300 in Figure 3C may be substantially similar to the electronic package 300 in Figure 3A, with the exception that the second nested component 340_{B} is facing a different direction. For example, the second nested component 340_{B} may have an active surface 341 that is facing away from the die 320.

Referring now to Figure 3D, a cross-sectional illustration of an electronic package 300 is shown, in accordance with an additional embodiment. In an embodiment, the electronic package 300 in Figure 3C may be substantially similar to the electronic package 300 in Figure 3A, with the exception that a stack of second nested components 340_{B} is positioned in the second cavity 335_{B}. In an embodiment, the stack of second nested components 340_{B} may comprise a stack of memory dies or any other stackable components.

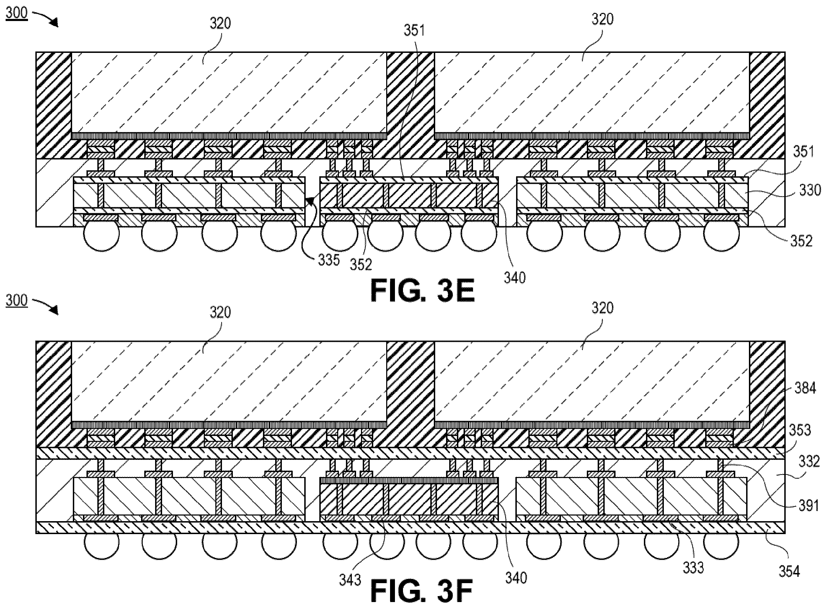

Referring now to Figure 3E, a cross-sectional illustration of an electronic package 300 is shown, in accordance with an embodiment. In an embodiment, the electronic package 300 may comprise an interposer 330, a nested component 340 in a cavity 335 in the interposer 330, and one or more dies 320 attached to the nested component 340 and the interposer 330. In an embodiment, the nested component 340 and/or the interposer 330 may comprise one or more redistribution layers 351, 352. For example, a redistribution layer 351 may be above the nested component 340 and the interposer 330 (i.e., facing the dies 320) and a redistribution layer 352 may be below the nested component 340 and the interposer 330. While the redistribution layers 351, 352 are shown on both the nested component 340 and the interposer 330, it is to be appreciated that in some embodiments, the redistribution layers 351, 352 may only be on one of the nested component 340 and the interposer 330. Additionally, while the redistribution layers 351, 352 are shown on both the top and bottom surfaces of the nested component 340 and the interposer 330, it is to be appreciated that in some embodiments, the redistribution layer 351 or 352 may be only on one surface of the nested component 340 and/or the interposer 330.

Referring now to Figure 3F, a cross-sectional illustration of an electronic package 300 is shown, in accordance with an additional embodiment. In an embodiment, the electronic package 300 may be substantially similar to the electronic package 300 in Figure 3E, with the exception that the redistribution layers 353 and 354 are positioned in different locations. For example, a redistribution layer 353 may be positioned over the mold layer 332 between the vias 391 and the intermediate pads 384 and/or a redistribution layer 354 may be located below the pads 333 of the interposer 330 and the pads 343 of the nested component 340. In the case where a redistribution layer 353 is located over the mold layer 332, it is to be appreciated that the intermediate pad 384 may optionally be integrated into the redistribution layer 353. While a redistribution layer 353 and 354 is shown in both locations in Figure 3F, it is to be appreciated that only one redistribution layer 353 or 354 may be used in some embodiments. In Figures 3E and 3F, various redistribution layers 351-354 are shown. However, it is to be appreciated that embodiments may include any number or combination of redistribution layers 351-354 or redistribution layers in other locations not illustrated in Figures 3E or 3F.

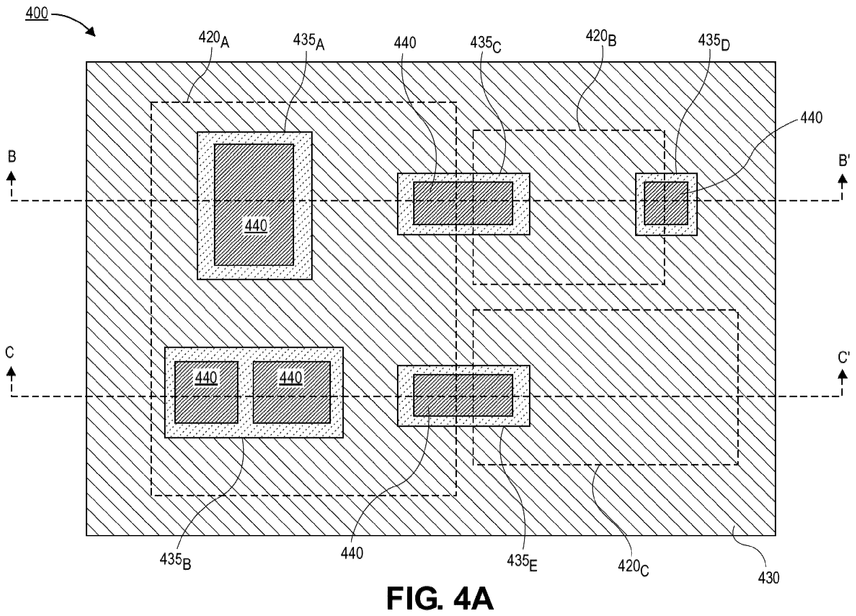

Referring now to Figure 4A, a plan view illustration of an electronic package 400 is shown, in accordance with an embodiment. In an embodiment, the electronic package 400 comprises an interposer 430 with a plurality of cavities 435_{A-E}. In an embodiment, a plurality of nested components 440 are positioned in the cavities 435. In some embodiments, at least one of the cavities 435 comprises a plurality of nested components 440. For example, two nested components 440 are positioned in cavity 435_{B}. In an embodiment, the cavities 435 may be entirely within a footprint of a die 420 (indicated by dashed lines), within the footprint of more than one die 420, and/or partially within the footprint of a single die 420. For example, cavities 435_{A} and 435_{B} are entirely within a footprint of die 420_{A}, cavity 435_{C} is within the footprint of die 420_{A} and 420_{B}, cavity 435_{E} is within the footprint of die 420_{A} and 420_{C}, and cavity 435_{D} is partially within the footprint of die 420_{B}.

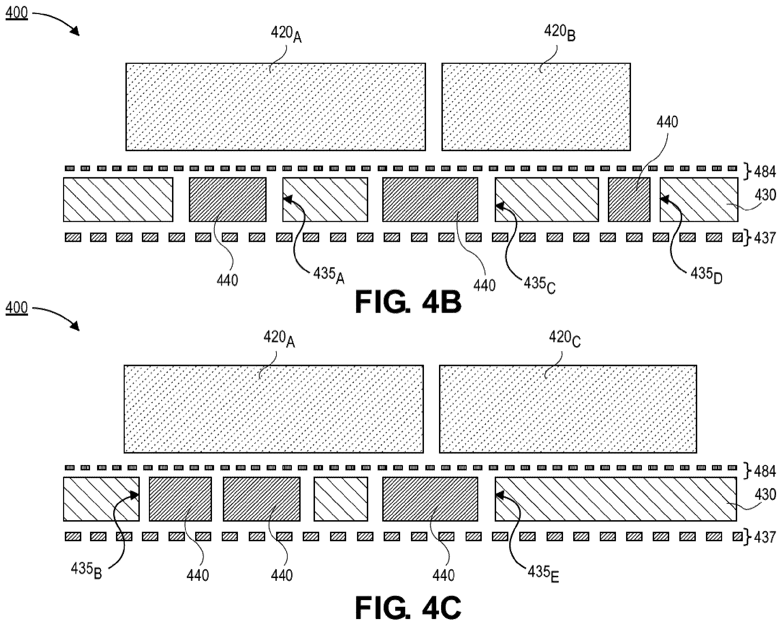

Referring now to Figure 4B, a cross-sectional schematic illustration of the electronic package 400 in Figure 4A along line B-B' is shown, in accordance with an embodiment. In the illustrated embodiment, the interposer 430 is shown with nested components 440 within cavities 435_{A}, 435_{C}, and 435_{D}. The interposer 430 and the nested components 440 may be electrically coupled to the dies 420_{A} and 420_{B} by interconnects that comprise a layer of intermediate pads 484. The intermediate pads 484 are shown schematically between the dies 420_{A}, 420_{B} and the interposer 430 and the nested components 440 for simplicity. However, it is to be appreciated that the intermediate pads 484 may be part of an interconnect substantially to the interconnects 181 and 182 described above with respect to Figures 1A-1C or interconnects 281 and 282 described above with respect to Figures 2A-2C. In an embodiment, the bottom surfaces of the interposer 430 and the nested components 440 may be electrically coupled to package side bumps 437.

Referring now to Figure 4C, a cross-sectional schematic illustration of the electronic package 400 in Figure 4A along line C-C' is shown, in accordance with an embodiment. In the illustrated embodiment, the interposer 430 is shown with nested components 440 within cavities 435_{B} and 435_{E}. The interposer 430 and the nested components 440 may be electrically coupled to the dies 420_{A} and 420_{B} by interconnects that comprise a layer of intermediate pads 484. The intermediate pads 484 are shown schematically between the dies 420_{A}, 420_{B} and the interposer 430 and the nested components 440 for simplicity. However, it is to be appreciated that the intermediate pads 484 may be part of an interconnect substantially to the interconnects 181 and 182 described above with respect to Figures 1A-1C or interconnects 281 and 282 described above with respect to Figures 2A-2C. In an embodiment, the bottom surfaces of the interposer 430 and the nested components 440 may be electrically coupled to package side bumps 437.

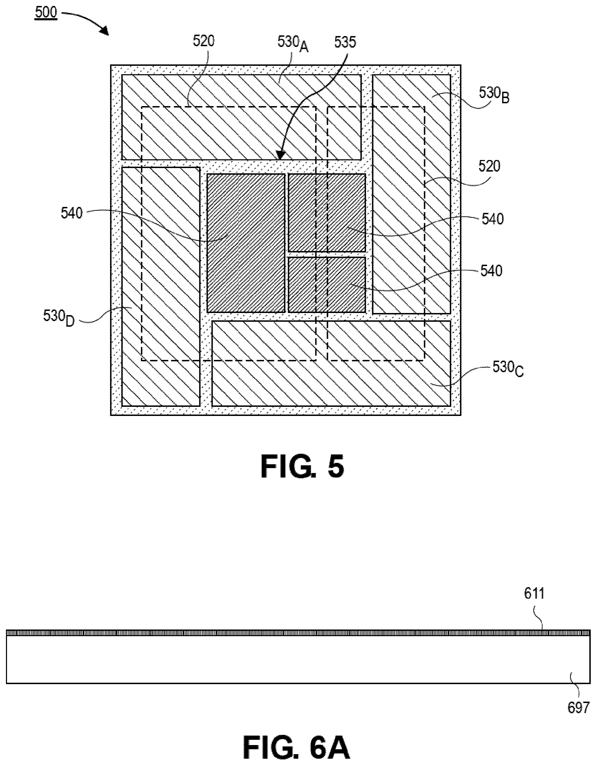

Referring now to Figure 5, a plan view illustration of an electronic package 500 is shown, in accordance with an embodiment. In an embodiment, the electronic package 500 may comprise a plurality of interposers 530_{A-D}. Each interposer 530 may be any shape. For example, the interposers 530 are illustrated as being rectilinear. The interposers 530 may be arranged so that sidewalls of the interposers 530 define a cavity 535. In an embodiment, one or more nested components 540 may be positioned in the cavity 535. In an embodiment, one or more dies 520 (indicated with dashed lines) may be provided above the interposers 530 and the nested components 540. Each of the dies 520 may extend over one or more of interposers 530.

In an embodiment, each of the interposers 530 may be substantially similar to each other. For example, each of the interposers 530 may be passive interposers 530 or active interposers 530. In other embodiments, the interposers 530 may not all be the same. For example, one or more of the interposers 530 may be an active interposer 530 and one or more of the interposers 530 may be a passive interposer.

Referring now to Figures 6A-6H, a series of cross-sectional illustrations depicting a process for forming an electronic package with a heterogeneous nested interposer is shown, in accordance with an embodiment.

Referring now to Figure 6A, a cross-sectional illustration of a carrier 697 with an adhesive 611 is shown, in accordance with an embodiment. In an embodiment, the carrier 697 may be any suitable carrier substrate, such as glass or the like. In an embodiment, any suitable adhesive 611 may be disposed over a surface of the carrier 697.

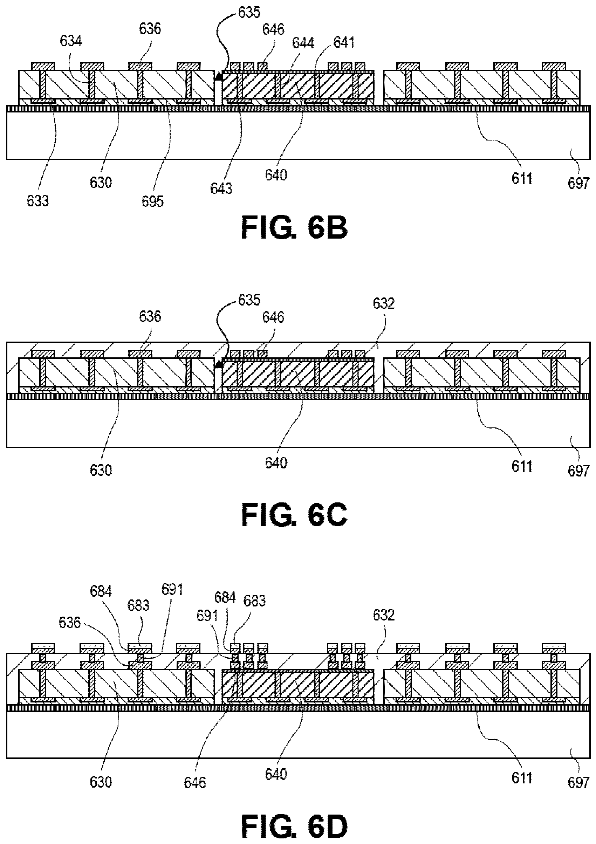

Referring now to Figure 6B, a cross-sectional illustration after the interposer 630 and the nested component 640 are attached to the carrier 697 is shown, in accordance with an embodiment. In an embodiment, the interposer 630 may comprise vias 634 that connect pads 633 on a first surface of the interposer 630 to interposer pads 636 on a second surface of the interposer 630. In an embodiment, the nested component 640 may be positioned within a cavity 635 of the interposer. In an embodiment, the nested component 640 may have an active surface 641 and through component vias 644. In the illustrated embodiment, the active surface 641 is facing away from the carrier 697. However, it is to be appreciate that in other embodiments, the active surface 641 may be facing towards the carrier 697. In other embodiments, the nested component 640 may not have through component vias 644. The nested component 640 may have pads 643 on a first surface and component pads 646 on a second surface. In an embodiment, the pads 643 and 633 may be spaced away from the adhesive 611 by a solder resist 695 or other suitable material layer.

In the illustrated embodiment, a single interposer 630 and nested component 640 are shown on the carrier 697. However, it is to be appreciated that the carrier 697 may be a panel level, sub-panel level, wafer-level, etc. carrier on which a plurality of electronic packages are fabricated substantially in parallel.

Referring now to Figure 6C, a cross-sectional illustration after a mold layer 632 is disposed over the exposed surfaces is shown, in accordance with an embodiment. In an embodiment, the mold layer 632 may embed the interposer 630 and the nested component 640. For example, the mold layer 632 may fill the cavity 635 so that portions of the mold layer 632 fill space between sidewalls of the nested component 640 and sidewalls of the interposer 630. In an embodiment, a top surface of the mold layer 632 is above top surfaces of the interposer pads 636 and the component pads 646. While referred to as a "mold layer", it is to be appreciated that mold layer 632 may be any suitable material or formed with any suitable material deposition process for packaging applications. For example, the mold layer 632 may be formed with a molding process, a lamination process, a deposition process, or the like.

Referring now to Figure 6D, a cross-sectional illustration after interconnects are made to the interposer pads 636 and the component pads 646 is shown, in accordance with an embodiment. In an embodiment, the interconnects may comprise a via 691, an intermediate pad 684 over the via 691, and a bump 683 over the intermediate pad 684. In an embodiment, the via openings for the vias 691 may be formed with a lithographic process or a laser drilling process. The vias 691 extend into the mold layer 632 and contact top surfaces of the interposer pads 636 and top surfaces of the component pads 646. In embodiments where the vias 691 are lithographically defined, the vias 691 will all be aligned with each other and correct for misalignment between the nested component 640 and the interposer 630.

In an embodiment, the intermediate pads 684 may be positioned over a top surface of the mold layer 632. The intermediate pads 684 may be fabricated with a lithographic process. As such, the intermediate pads 684 may also be aligned with respect to each other and provide correction for misalignment between the nested component 640 and the interposer 630. In an embodiment, bumps 683 are disposed over the top surfaces of the intermediate pads 684. The bumps 683 may be solder bumps or the like.

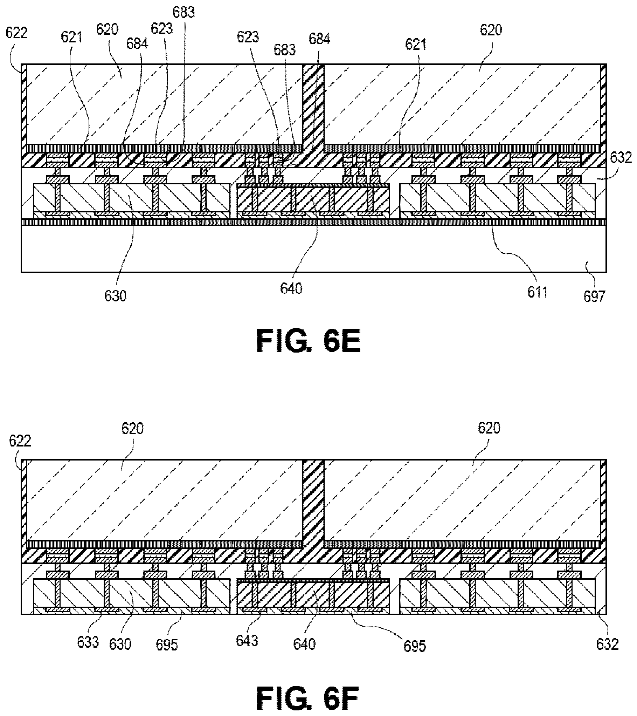

Referring now to Figure 6E, a cross-sectional illustration after dies 620 are attached to the interposer 630 and the nested component 640 is shown, in accordance with an embodiment. In an embodiment, the dies 620 may have active surfaces 621 that face towards the mold layer 632. In an embodiment, the dies 620 may have die pads 623 that are electrically coupled to the intermediate pads 684 by the bumps 683. In an embodiment, a mold layer 622 may embed the dies 620. The mold layer 622 may also surround the intermediate pads 684 and the bumps 683. In other embodiments, an underfill material (not shown) may surround the interconnects. In an embodiment, the mold layer 622 may be recessed (e.g., with a chemical mechanical planarizing (CMP) process or the like) to expose backside surfaces of the dies 620.

Referring now to Figure 6F, a cross-sectional illustration after the carrier 697 is removed is shown, in accordance with an embodiment. In an embodiment, the carrier 697 and the adhesive 611 is removed with any suitable processes. The removal of the carrier 697 and the adhesive 611 exposes portions of the mold layer 632 and the resist layer 695 over the package side pads 633 and 643.

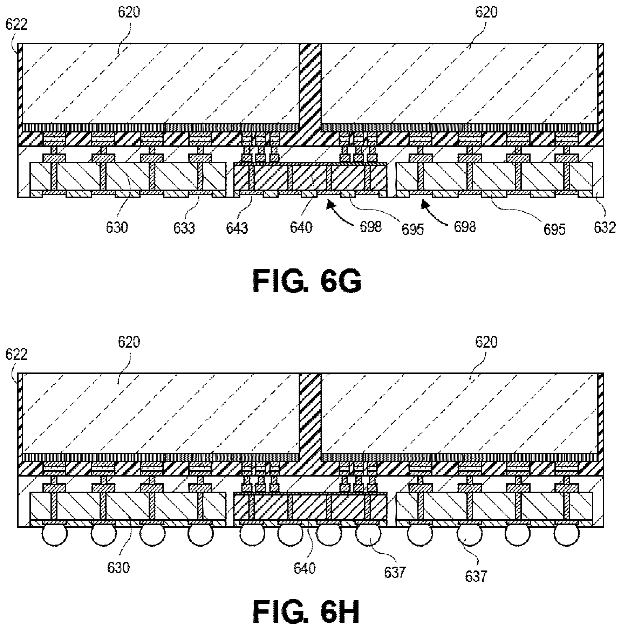

Referring now to Figure 6G, a cross-sectional illustration after openings 698 are formed into resist layer 695 to expose package side pads 633 and 643 of the interposer 630 and the nested component 640, respectively, is shown, in accordance with an embodiment. In an embodiment, the openings 698 may be formed with a laser drilling process or a lithography process.

Referring now to Figure 6H, a cross-sectional illustration after bumps 637 are disposed in the openings 698 is shown, in accordance with an embodiment. The bumps 637 may be referred to as package side bumps (PSBs) since they will interface with a package substrate (not shown). However, it is to be appreciated that other interconnect architectures (e.g., LGA, PGA, PoINT, eWLB, or the like) may be used instead of the bumps 637 in the BGA architecture shown. In an embodiment, the individual electronic packages may be singulated from the panel-level assembly after (or before) the formation of the PSBs 637.

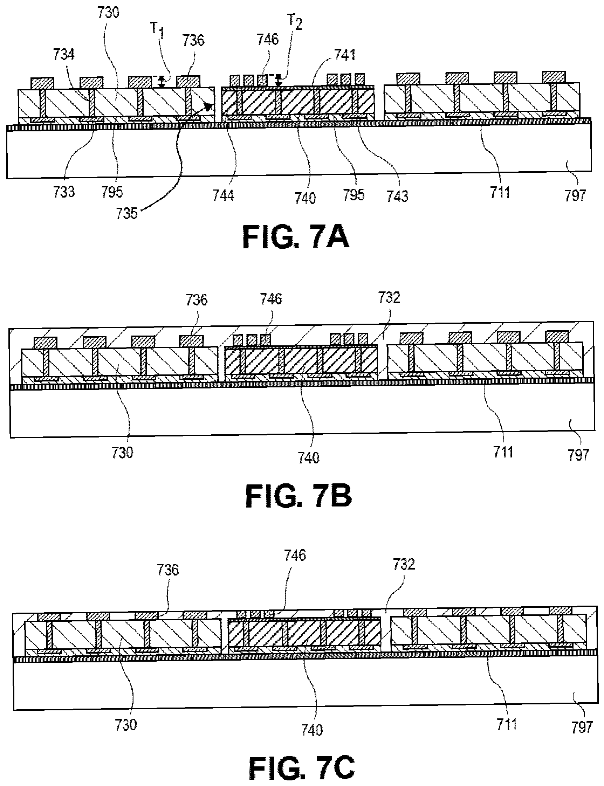

Referring now to Figures 7A-7G, a series of cross-sectional illustrations depicting a process for forming an electronic package with a heterogeneous nested interposer is shown, in accordance with an additional embodiment.

Referring now to Figure 7A, a cross-sectional illustration of an interposer 730 and a nested component 740 attached to a carrier 797 by an adhesive 711 is shown, in accordance with an embodiment. In an embodiment, the interposer 730 may comprise vias 734 that connect pads 733 on a first surface of the interposer 730 to interposer pads 736 on a second surface of the interposer 730. In an embodiment, the nested component 740 may be positioned within a cavity 735 of the interposer 730. In an embodiment, the nested component 740 may have an active surface 741 and through component vias 744. In the illustrated embodiment, the active surface 741 is facing away from the carrier 797. However, it is to be appreciate that in other embodiments, the active surface 741 may be facing towards the carrier 797. In other embodiments, the nested component 740 may not have through component vias 744. The nested component 740 may have pads 743 on a first surface and component pads 746 on a second surface. In an embodiment, the pads 743 and 733 may be spaced away from the adhesive 711 by a solder resist 795 or other suitable material layer.

In an embodiment, the interposer pads 736 may have a first thickness T₁, and the component pads 746 may have a second thickness T₂. In an embodiment, the first thickness T₁ and the second thickness T₂ may be substantially larger than typical pads. For example, the first thickness T₁ and the second thickness T₂ may be approximately 30 µm or larger. In some embodiments, aspect ratios of the interposer pads 736 and the component pads 746 (thickness:width) may be approximately 1:1 or greater, or 2:1 or greater. In some embodiments, the first thickness T₁ may be different than the second thickness T₂. For example, different thicknesses for T₁ and T₂ may be used to account for different Z-heights of the interposer 730 and the nested component 740.

In the illustrated embodiment, a single interposer 730 and nested component 740 are shown on the carrier 797. However, it is to be appreciated that the carrier 797 may be a panel level, sub-panel level, wafer-level, etc. carrier on which a plurality of electronic packages are fabricated substantially in parallel.

Referring now to Figure 7B, a cross-sectional illustration after a mold layer 732 is disposed over the exposed surfaces is shown, in accordance with an embodiment. In an embodiment, the mold layer 732 may embed the interposer 730 and the nested component 740. For example, the mold layer 732 may fill the cavity 735 so that portions of the mold layer 732 fill space between sidewalls of the nested component 740 and sidewalls of the interposer 730. In an embodiment, a top surface of the mold layer 732 is above top surfaces of the interposer pads 736 and the component pads 746. While referred to as a "mold layer", it is to be appreciated that mold layer 732 may be any suitable material or formed with any suitable material deposition process for packaging applications. For example, the mold layer 732 may be formed with a molding process, a lamination process, a deposition process, or the like.

Referring now to Figure 7C, a cross-sectional illustration after the mold layer 732 is recessed is shown, in accordance with an embodiment. Recessing the mold layer 732 exposes top surfaces of the interposer pads 736 and top surfaces of the component pads 746. The recessing also planarizes top surfaces of the interposer pads 736 and top surfaces of the component pads 746 so that they are substantially coplanar. Accordingly, any discontinuities in the Z-height are eliminated. In an embodiment, the recessing may be implemented with a CMP process or the like.

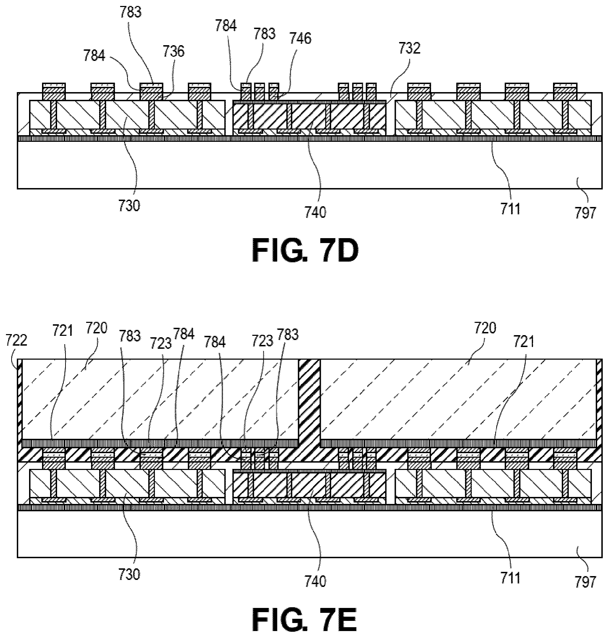

Referring now to Figure 7D, a cross-sectional illustration after intermediate pads 784 and bumps 783 are disposed over the interposer pads 736 and the component pads 746 is shown, in accordance with an embodiment. In an embodiment, the intermediate pads 784 may be positioned over a top surface of the mold layer 732. The intermediate pads 784 may be fabricated with a lithographic process. As such, the intermediate pads 784 may be aligned with respect to each other and provide correction for misalignment between the nested component 740 and the interposer 730. In an embodiment, bumps 783 are disposed over the top surfaces of the intermediate pads 784. The bumps 783 may be solder bumps or the like.

Referring now to Figure 7E, a cross-sectional illustration after dies 720 are attached to the interposer 730 and the nested component 740 is shown, in accordance with an embodiment. In an embodiment, the dies 720 may have active surfaces 721 that face towards the mold layer 732. In an embodiment, the dies 720 may have die pads 723 that are electrically coupled to the intermediate pads 784 by the bumps 783. In an embodiment, a mold layer 722 may embed the dies 720. The mold layer 722 may also surround the intermediate pads 784 and the bumps 783. In other embodiments, an underfill material (not shown) may surround the interconnects. In an embodiment, the mold layer 722 may be recessed (e.g., with a CMP process or the like) to expose backside surfaces of the dies 720.

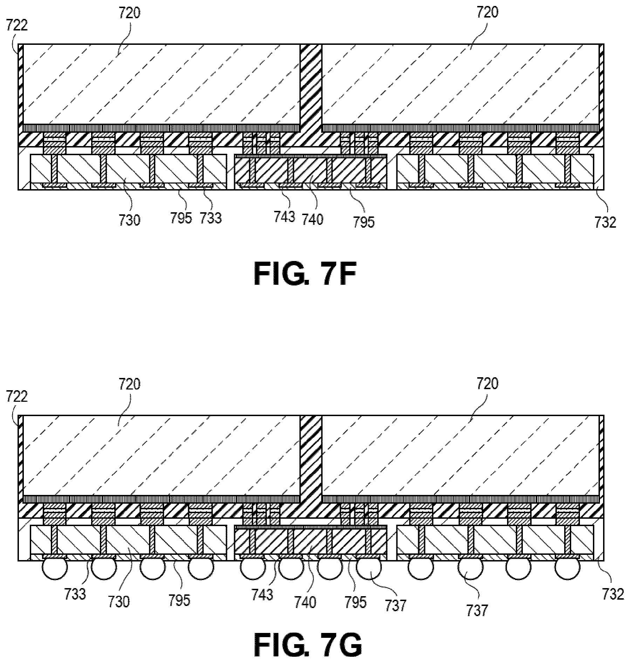

Referring now to Figure 7F, a cross-sectional illustration after the carrier 797 is removed is shown, in accordance with an embodiment. In an embodiment, the carrier 797 and the adhesive 711 is removed with any suitable processes. The removal of the carrier 797 and the adhesive 711 exposes portions of the mold layer 732 and the resist layer 795 over the package side pads 733 and 743.

Referring now to Figure 7G, a cross-sectional illustration after openings are formed into resist layer 795 and bumps 737 are attached to package side pads 733 and 743 of the interposer 730 and the nested component 740, respectively, is shown, in accordance with an embodiment. In an embodiment, the openings may be formed with a laser drilling process or a lithography process. The bumps 737 may be referred to as package side bumps (PSBs) since they will interface with a package substrate (not shown). However, it is to be appreciated that other interconnect architectures (e.g., LGA, PGA, PoINT, eWLB, or the like) may be used instead of the bumps 737 in the BGA architecture shown. In an embodiment, the individual electronic packages may be singulated from the panel-level assembly after (or before) the formation of the PSBs 737.

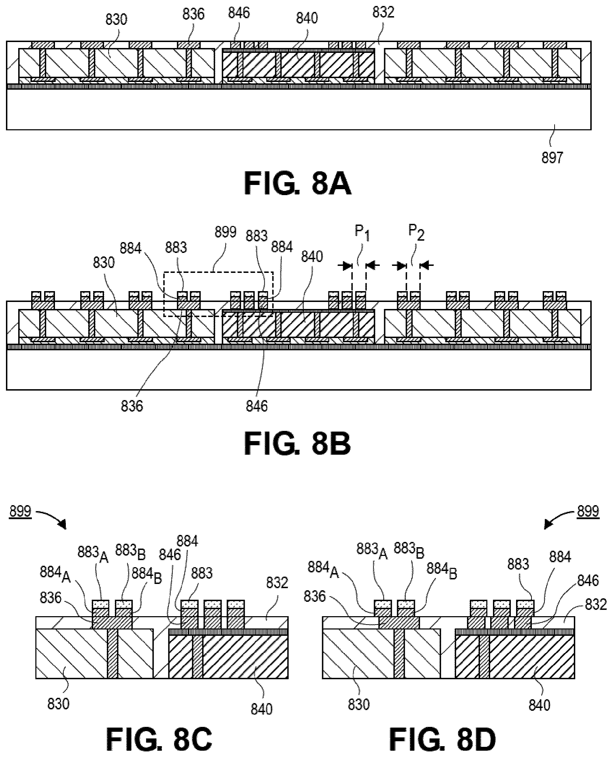

Referring now to Figures 8A-8D, a series of cross-sectional illustrations depict a process for forming interconnects with uniform bump pitches. In the embodiments disclosed above, the bump pitch over the interposer pads is larger than the bump pitch over the component pads. However, additional embodiments may include a uniform bump pitch over the interposer pads and the component pads. A uniform bump pitch may improve manufacturability of the electronic package.

Referring now to Figure 8A, a cross-sectional illustration of an interposer 830 and a nested component 840 on a carrier 897 after the mold layer 832 has been recessed to expose the interposer pads 836 and the component pads 846 is shown, in accordance with an embodiment. In an embodiment, the structure in Figure 8A may be substantially similar to the structure illustrated and described with respect to Figure 7C.

Referring now to Figure 8B, a cross-sectional illustration after intermediate pads 884 and bumps 883 are disposed over the interposer pads 836 and the component pads 846 is shown, in accordance with an embodiment. As shown, the bump pitch P₁ over the component pads 846 may be substantially similar to the bump pitch P₂ over the interposer pads 836. Particularly, the bump pitch P₂ is reduced by forming a plurality of intermediate pads 884 and bumps 883 over each interposer pad 836.

Referring now to Figure 8C, a zoomed in cross-sectional illustration of region 899 in Figure 8B is shown, in accordance with an embodiment. As shown, a first intermediate pad 884_{A} and a second intermediate pad 884_{B} (and a first bump 883_{A} and a second bump 883_{B}) are disposed over each of the interposer pads 836.

In Figure 8C, the interposer 830 and the nested component 840 are shown as being perfectly aligned. However, as discussed above, there may be misalignment between the interposer 830 and the nested component 840. Such an embodiment is shown in Figure 8D. As shown, the misalignment may be accommodated by the intermediate pads 884. So long as the intermediate pads 884 land on some surface of the component pads 846 or the interposer pads 836 (without also landing on a neighboring component pad 846 or interposer pad 836) the misalignment can be corrected.

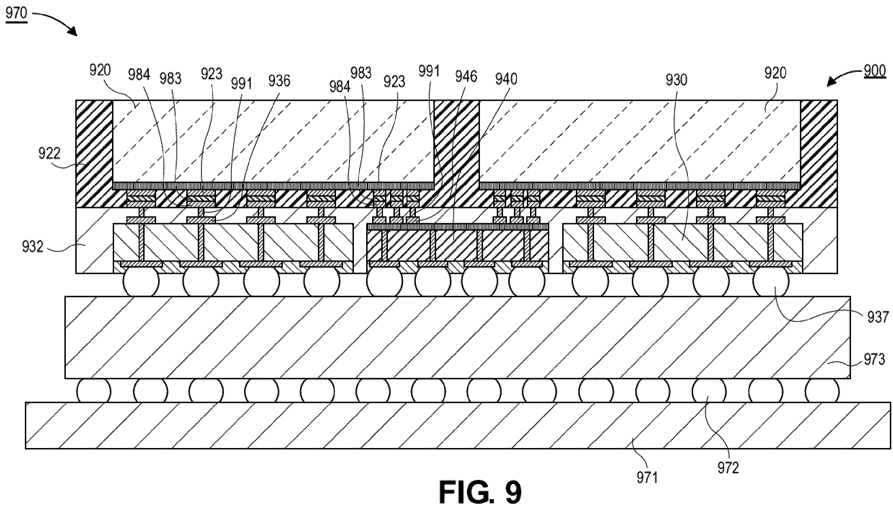

Referring now to Figure 9, a cross-sectional illustration of an electronic system 970 is shown, in accordance with an embodiment. In an embodiment, the electronic system 970 may comprise a board 971 (e.g. a printed circuit board (PCB)) that is coupled to a package substrate 973 by interconnects 972. The interconnects 972 are shown as being solder bumps. However, it is to be appreciated that any interconnect architecture may be used. In an embodiment, the electronic system 970 may comprise an electronic package 900 that is coupled to the package substrate 973 with package side bumps 937. In some embodiments, the electronic package 900 is coupled directly to the board 971. That is, the package substrate 973 may be optionally omitted.

The electronic package 900 may be substantially similar to the electronic packages described above. For example, the electronic package may comprise an interposer 930 and one or more nested components 940 embedded in a mold layer 932. One or more dies 920 may be electrically coupled to the interposer 930 and the nested component 940 by interconnects. The one or more dies 920 may be embedded in a mold layer 922. In an embodiment, the interconnects may comprise an intermediate pad 984 over vias 991 that are connected to interposer pads 936 or component pads 946, similar to the embodiments described above with respect to Figures 1A-1C. Similar electronic systems may also be formed with interconnects that omit the vias 991, similar to the embodiment described above with respect to Figures 2A-2C. The interconnects may also comprise bumps 983 that are connected to die pads 923.

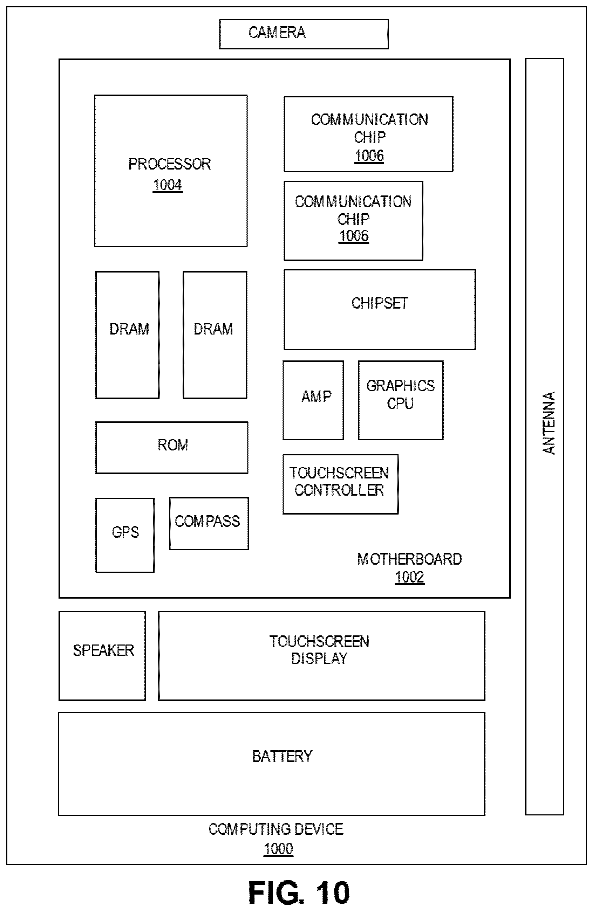

Figure 10 illustrates a computing device 1000 in accordance with one implementation of the invention. The computing device 1000 houses a board 1002. The board 1002 may include a number of components, including but not limited to a processor 1004 and at least one communication chip 1006. The processor 1004 is physically and electrically coupled to the board 1002. In some implementations the at least one communication chip 1006 is also physically and electrically coupled to the board 1002. In further implementations, the communication chip 1006 is part of the processor 1004.

These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1006 enables wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing device 1000 includes an integrated circuit die packaged within the processor 1004. In some implementations of the invention, the integrated circuit die of the processor may be packaged in an electronic system that comprises a multi-chip package with an interposer and a nested component that are coupled to one or more dies by interconnects that comprises an intermediate pad, in accordance with embodiments described herein. The term "processor" may refer to any device or portion of a device that processes electronic data from registers and/or memory to transform that electronic data into other electronic data that may be stored in registers and/or memory.

The communication chip 1006 also includes an integrated circuit die packaged within the communication chip 1006. In accordance with another implementation of the invention, the integrated circuit die of the communication chip 1006 may be packaged in an electronic system 1000 that comprises a multi-chip package with an interposer and a nested component that are coupled to one or more dies by interconnects that comprises an intermediate pad, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: an interposer, wherein the interposer comprises: a cavity that passes through the interposer; a through interposer via (TIV); and an interposer pad electrically coupled to the TIV; a nested component in the cavity, wherein the nested component comprises a component pad; and a die coupled to the interposer pad by a first interconnect and coupled to the component pad by a second interconnect, wherein the first interconnect and the second interconnect each comprise: an intermediate pad; and a bump over the intermediate pad.

Example 2: the electronic package of Example 1, further comprising: a polymer layer over and around the interposer and the nested component.

Example 3: the electronic package of Example 2, wherein the intermediate pads are over a surface of the mold layer.

Example 4: the electronic package of Example 3, wherein the intermediate pad of the first interconnect is coupled to the interposer pad by a first via that passes through a portion of the mold layer, and wherein the intermediate pad of the second interconnect is coupled to the component pad by a second via that passes through a portion of the mold layer.

Example 5: the electronic package of Example 3, wherein the intermediate pad of the first interconnect is directly connected to the interposer pad, and wherein the intermediate pad of the second interconnect is directly connected to the component pad.

Example 6: the electronic package of Examples 1-5, wherein a centerline of the first interconnect is offset from a centerline of the interposer pad, and wherein a centerline of the second interconnect is offset from a centerline of the component pad.

Example 7: the electronic package of Examples 1-6, wherein the cavity is entirely within a footprint of the die.

Example 8: the electronic package of Examples 1-7, wherein a first portion of the cavity is within a footprint of the die, and wherein a second portion of the cavity is outside of the footprint of the die.

Example 9: the electronic package of Examples 1-8, wherein through component vias extend through the nested component.

Example 10: the electronic package of Examples 1-9, wherein the nested component is a passive component or an active component.

Example 11: the electronic package of Examples 1-10, further comprising: a second die, wherein the second die is coupled to the nested component by a third interconnect comprising: an intermediate pad; and a bump over the intermediate pad.

Example 12: the electronic package of Example 11, wherein the nested component electrically couples the first die to the second die.

Example 13: the electronic package of Examples 1-12, further comprising: a second nested component in the cavity.

Example 14: the electronic package of Examples 1-13, wherein an active surface of the nested component faces away from the die or faces towards the die.

Example 15: the electronic package of Examples 1-14, wherein the nested component comprises a plurality of stacked dies.

Example 16: the electronic package of Examples 1-15, wherein the interposer comprises a plurality of discrete interposer substrates, wherein edges of the plurality of discrete interposer substrates define the cavity.

Example 17: the electronic package of Examples 1-16, wherein the interposer comprises glass, ceramic, silicon, silicon carbide, alumina, or organic materials.

Example 18: the electronic package of Examples 1-17, further comprising one or more redistribution layers, wherein the one or more redistribution layers are located over one or more of a top surface of the interposer, a bottom surface of the interposer, a top surface of the nested component, a bottom surface of the nested component, a top surface of a mold layer that embeds the interposer and the nested component, and a bottom surface of the mold layer.

Example 19: an electronic system, comprising: a board; an interposer electrically coupled to the board, wherein the interposer comprises a cavity; a nested component in the cavity, wherein the nested component is electrically coupled to the package substrate; a first die electrically coupled to the interposer and the nested component by interconnects; and a second die electrically coupled to the interposer and the nested component by a plurality of interconnects, wherein the interconnects each comprise: an intermediate pad; and a bump over the intermediate pad.

Example 20: the electronic system of Example 19, wherein the nested component electrically couples the first die to the second die.

Example 21: the electronic system of Example 19 or Example 20, wherein the interconnects comprise a uniform bump pitch.

Example 22: the electronic system of Examples 19-21, further comprising: a package substrate, wherein the package substrate is electrically coupled to the board, and wherein the interposer is electrically coupled to the package substrate.

Example 23: a method of forming an electronic package, comprising: attaching an interposer to a carrier, wherein the interposer comprises a cavity and a plurality of interposer pads; attaching a nested component to the carrier, wherein the nested component sits within the cavity, and wherein the nested component comprises a plurality of component pads; disposing a first mold layer over the interposer and the carrier; disposing a plurality of intermediate pads over the first mold layer, wherein each intermediate pad is electrically coupled to one of the interposer pads or one of the component pads; disposing a plurality of bumps over each of the intermediate pads; attaching a die to the bumps; embedding the die in a second mold layer; and removing the carrier.

Example 24: the method of Example 23, further comprising: forming a plurality of vias into the first mold layer, wherein each via electrically couples one of the intermediate pads to one of the component pads or one of the interposer pads.

Example 25: the method of Example 23 or Example 24, wherein each intermediate pad is directly attached to one of the component pads or one of the interposer pads.

## Claims

1. An electronic package (100, 200, 300) comprising:
an interposer (130), wherein the interposer comprises:
a first plurality of through interposer vias (134) through the interposer; and
a second plurality of through interposer vias (134) through the interposer;
a nested component (140) in the interposer, wherein the nested component is between the first plurality of through interposer vias and the second plurality of through interposer vias, the nested component comprising a frontside , a backside and a plurality of through component vias (144) between the front side and the backside;
a die (120) coupled to the first plurality of through interposer vias by first interconnects (181) and coupled to the front side of the nested component by second interconnect (182); and
a redistribution layer (354) below the interposer, the redistribution layer coupled to the first plurality of through interposer vias, the second plurality of through interposer vias, and the backside of the nested component.

2. The electronic package of claim 1, wherein the interposer (130) comprises a molded substrate.

3. The electronic package of one of the previous claims, wherein each first interconnect of the first interconnects comprises a pad (123) and a bump (283) over and in contact with the pad.

4. The electronic package of one of the previous claims, wherein the interposer (130) comprises a cavity (135), and the nested component is in the cavity.

5. The electronic package of one of the previous claims, wherein the redistribution layer (354) is coupled to the plurality of through component vias (144).

6. The electronic package of one of the previous claims, further comprising a plurality of balls (337) coupled to a backside of the redistribution layer (354).

7. The electronic package of one of the previous claims, further comprising a second redistribution layer (353) between the interposer (130) and the die (120), and between the nested component (140) and the die (120).

8. The electronic package of one of the previous claims, further comprising a second die (120) coupled to the second plurality of through interposer vias (134) by third interconnects and coupled to the front side of the nested component (140) by fourth interconnects.

9. The electronic package of one of the previous claims, wherein the nested component (140) is a multi-die interconnect bridge.

10. The electronic package of one of the previous claims, further comprising a dielectric layer (132) between the interposer (130) and the nested component (140), wherein the dielectric layer is along a first sidewall of the nested component and a second sidewall of the nested component, and the dielectric layer is between the first sidewall of the nested component and the first plurality of through interposer vias (134), and between the second sidewall of the nested component and the second plurality of through interposer vias (134).

11. The electronic package of claim 10, wherein the redistribution layer (354) is below and in contact with the dielectric layer (132).
